# EUROPÄISCHE PATENTANMELDUNG

(11) **EP 0 547 525 A1**
(43) Veröffentlichungstag der Anmeldung: **23.06.1993**
(21) Anmeldenummer: 92121161.1
(22) Anmeldetag: 11.12.1992
(51) Int. Cl.: H03K 19/0948, H03K 19/0185

(54) **CMOS-Treiberstufe**

(30) Priorität: 18.12.1991 DE 4141886
(71) Anmelder: SIEMENS AKTIENGESELLSCHAFT, D-80333 München (DE)
(72) Erfinder: Scianna, Cosimo, Dott. Ing., W-8000 München 83 (DE)

(57) **Zusammenfassung**

Eine Inverterstufe, bestehend aus einer Gegentaktstufe (6, 9), wird derart erweitert, daß sie eine Tri-state-Treiberstufe bildet. Hierzu werden drei zusätzliche Transistoren (3, 4, 8) benötigt. Den Steueranschlüssen der drei zusätzlichen Transistoren (3, 4, 8) wird ein Aktivierungssignal zugeführt. Die Laststrecke des ersten zusätzlichen Transistors (3) ist zwischen Eingangsklemme und den Steueranschlüssen der Gegentaktendstufe (6, 9) geschaltet. Zwischen den Steueranschlüssen der Gegentaktendstufe (6, 9) und der Versorgungsspannungsklemme (5) ist die Laststrecke des zweiten zusätzlichen Transistors (4) geschaltet. Schließlich wird die Laststrecke des dritten zusätzlichen Transistors (8) zwischen die Reihenschaltung der Laststrecken der Gegentaktendstufe (6, 9) geschaltet. Das Ausgangssignal kann am Knotenpunkt (7) des mit der Versorgungsspannung verbundenen Gegentakttransistors (6) und der Laststrecke des dritten zusätzlichen Transistors (8) abgegriffen werden.

## Beschreibung

Die Erfindung betrifft eine Treiberstufe mit Tri-state-Ausgang.

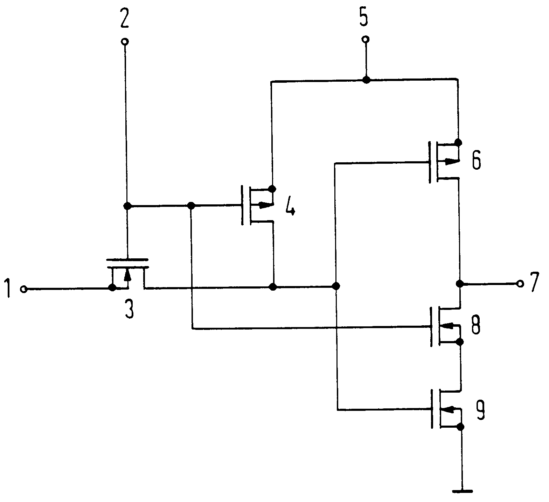

Eine gattungsgemäße Treiberstufe ist z. B. aus "CMOS Digital Circuit Technology" von Masakazu Shoji, 1988, auf Seite 81 in Figur 2.19 dargestellt. Der in Teilfigur b dargestellte Tri-state-Treiber weist ein NAND- und ein NOR-Gatter auf, deren Ausgänge jeweils mit den Gateanschlüssen eines p- und eines n-Kanal-FETs verbunden sind. Der p- und n-Kanal-FET bilden eine Gegentaktendstufe, an deren Ausgang das Tri-state-Ausgangssignal abgreifbar ist. Jeweils der erste Eingang des NAND- bzw. NOR-Gatters wird mit einem Datensignal beaufschlagt. Dem anderen Eingang des NOR-Gatters wird ein Tri-state-Aktivierungssignal zugeführt, und dem anderen Eingang des NAND-Gatters das invertierte Tristate-Aktivierungssignal. Die dargestellte Schaltung ermöglicht es, drei verschiedene Zustände am Ausgang einzustellen. Ist das Tri-state-Aktivierungssignal aktiviert, so werden beide FETs der Gegentaktendstufe gesperrt und der Ausgang befindet sich in einem hochohmigen Zustand. Ist das Tri-state-Aktivierungssignal deaktiviert, so wird abhängig vom Dateneingangssignal entweder eine logische "0" oder eine logische "1" am Ausgang erzeugt. Teilfigur d zeigt eine Realisierung eines derartigen Tri-state-Buffers. Sie weist acht Feldeffekttransistoren auf. Dies hat den Nachteil, daß bei hohen Integrationsdichten relativ viel Platz für einen bei komplexen Schaltungen sehr häufig notwendigen Tri-state-Buffer benötigt wird.

Aufgabe der Erfindung ist es daher, einen Tri-state-Buffer anzugeben, der möglichst wenig Bauelemente und damit möglichst wenig Platz beansprucht.

Diese Aufgabe wird durch den kennzeichnenden Teil des Anspruchs 1 gelöst.

Die Schaltung weist den wesentlichen Vorteil auf, da sie mit lediglich fünf Feldeffekttransistoren auskommt. Verzögerungszeiten, die zwischen Ein- und Ausgangssignal entstehen können, werden dadurch ebenfalls minimiert.

Die Erfindung wird nachfolgend anhand einer einzigen Figur näher erläutert.

Die Erfindung zeigt eine erfindungsgemäße Ausführungsform einer Treiberstufe mit Tri-State-Ausgang. Eine Eingangsklemme 1 ist vorgesehen, an der z. B. ein Datensignal anlegbar ist. Diese Klemme ist mit dem Sourceanschluß eines ersten n-Kanal-FETs 3 verbunden. Der Drainanschluß des FETs 3 ist zum einen mit dem Sourceanschluß eines p-Kanal-FETs 4 und zum anderen sowohl mit dem Gateanschluß eines p-Kanal-FETs 6 wie auch mit dem Gateanschluß eines n-Kanal-FETs 9. Ein weiterer n-Kanal-FET 8 ist vorgesehen, dessen Gateanschluß sowohl mit dem Gateanschluß des FETs 3 wie auch mit dem Gateanschluß des FETs 4 verbunden ist. Weiterhin sind die Gateanschlüsse der drei FETs 3, 4 und 8 mit einer zweiten Klemme 2 verschaltet. An diese Klemme 2 ist ein Tri-state-Aktivierungssignal anlegbar. Der Drainanschluß des FETs 4 ist mit einer Eingangsklemme 5 angeschlossen, an der die Versorgungsspannung anschließbar ist. Die Eingangsklemme 5 ist weiterhin über die Reihenschaltung der Laststrecken des FETs 6, des FETs 8 und des FETs 9 mit Masse verbunden. Am Knotenpunkt der Reihenschaltung der Laststrecken des FETs 6 und des FETs 8 wird das Ausgangssignal abgegriffen und einer Ausgangsklemme 7 zugeführt.

Wird an der Eingangsklemme 2 ein logisches Nullsignal angelegt, so sperren der FET 3 und FET 8, wohingegen der FET 4 in den leitenden Zustand geschaltet wird. Dadurch liegt an den Gateanschlüssen der FETs 6 und 9 ein logisches "1"-Signal an. Dieses bewirkt, daß der FET 6 gesperrt und der FET 9 leitend geschaltet wird. Durch die Zwischenschaltung der Laststrecke des FETs 8 zwischen Ausgangsklemme und Laststrecke des FETs 9 und durch den Umstand daß dieser sperrt, wird der Ausgang hochohmig, also in den Tri-state-Zustand, geschaltet.

Liegt hingegen an der Eingangsklemme 2 ein logisches Einssignal an, so leitet der FET 3 und der FET 8, wohingegen der FET 4 gesperrt wird. Die Anordnung verhält sich nun wie eine übliche CMOS-Inverterstufe. Bei Anlegen eines logischen "1"-Signals an der Klemme 1 wird der FET 6 gesperrt und der FET 9 leitend geschaltet und bei Anlegen einer logischen "0" an der Klemme 1 wird der FET 6 leitend und der FET 9 gesperrt geschaltet. Dadurch ist in diesen Modus an der Ausgangsklemme 7 ein logisches "1"- oder "0"-Signal abgreifbar.

Die erfindungsgemäße Schaltungsanordnung eignet sich für alle digitalen Schaltungen insbesondere für hochintegrierte Schaltungen. Sie ist auch in komplementärer Schaltungstechnik realisierbar.

## Patentansprüche

1. Treiberstufe mit "Tri-state"-Ausgang,
**dadurch gekennzeichnet,** daß
- ein erster Feldeffekttransistor (3) von einem ersten Leitungstyp vorgesehen ist, über dessen Laststrecke den Gateanschlüssen eines zweiten Feldeffekttransistors (6) von einem zweiten Leitungstyp und eines dritten Feldeffekttransistors (9) vom ersten Leitungstyp ein Eingangssignal zugeführt wird,
- ein vierter Feldeffekttransistor (4) vom zweiten Leitungstyp vorgesehen ist, dessen Gateanschluß mit dem Gateanschluß des ersten Feldeffekttransistors (3) verbunden ist und dessen Laststrecke zwischen einem ersten Betriebspotentialabschluß (5) und den Gateanschlüssen des zweiten und dritten Feldeffekttransistors (6, 9) geschaltet ist,
- ein fünfter Feldeffekttransistor (8) vom ersten Leitungstyp vorgesehen ist, dessen Gateanschluß mit den Gateanschlüssen des zweiten und vierten Feldeffekttransistors (6, 4) verbunden sind und denen ein Aktivierungssignal über eine Anschlußklemme (2) zugeführt wird, - die Laststrecke des zweiten Feldeffekttransistors (6) in Reihe mit der Laststrecke des fünften Feldeffekttransistors (8) und der Laststrecke des dritten Feldeffekttransistors (9) geschaltet ist,
- die Reihenschaltung der drei Laststrecken einerseits über die Laststrecke des dritten Feldeffekttransistors mit einem zweiten Betriebspotentialanschluß (Masse) und andererseits über die Laststrecke des zweiten Feldeffekttransistors (6) mit dem ersten Betriebspotentialanschluß (5) verbunden ist,
- am Knotenpunkt der Reihenschaltung der Laststrecke des zweiten und fünften Feldeffekttransistors (6, 8) das Ausgangssignal abgreifbar ist.
